# EUROPEAN PATENT SPECIFICATION

(11) **EP 0 729 232 B1**
(45) Date of publication and mention of the grant of the patent: **17.09.2003**
(21) Application number: 95830051.9
(22) Date of filing: 22.02.1995
(51) Int. Cl.: H03K 17/16

(54) **A high voltage analog switch**
Hochspannungs-Analogschalter
Commutateur analogique haute tension

(43) Date of publication of application: 28.08.1996
(73) Proprietor: TEXAS INSTRUMENTS INCORPORATED, Dallas, Texas 75243 (US); TEXAS INSTRUMENTS ITALIA S.p.A., 67051 Avezzano (AQ) (IT)
(72) Inventor: Marotta, Giulio Giuseppe, Texas Inst. Italia S.p.A, I-67051 Avezzano (AQ) (IT)
(74) Representative: Taliercio, Antonio

(56) References cited:
- EP-A- 0 292 913
- EP-A- 0 346 898
- EP-A- 0 499 110
- US-A- 4 001 606
- US-A- 5 065 057
- INTERNATIONAL ELECTRON DEVICES MEETING, TECHNICAL DIGEST, 11 December 1988, SAN FRANCISCO, CA (US) pages 800 - 803 SCOTT ET AL. 'High voltage pullup devices in a BIMOS HVIC technology'
- SOCIETY FOR INFORMATION DISPLAY, INTERNATIONAL SYMPOSIUM, DIGEST OF TECHNICAL PAPERS, vol.XVIII, 12 May 1987, NEW ORLEANS, LOUISIANA (US) pages 295 - 298 CHANNING ET AL. 'Drive System for a 640x200 DCEL Display'

## Description

### TECHNICAL FIELD OF THE INVENTION

This invention relates generally to the field of semiconductor integrated circuits, and more particularly, to integrated circuit analog switches.

### BACKGROUND OF THE INVENTION

Semiconductor integrated circuits (ICs) can be designed to function as switches. In particular, digital logic switching and linear-signal switching are among the most important of applications in which field effect transistor (FET) circuits are used. A common use of MOSFETs is as analog switches. An ideal analog switch behaves like a mechanical switch. In the "ON" state, the analog switch passes a signal through to the load, while in the "OFF" state the switch acts as an open circuit. Analog switches are used in numerous applications, such as, for example, high-speed switches (e.g., MOS memory), linear switching devices, application-specific products (e.g., multiplexers), and analog-to-digital converters.

A design problem with existing analog switches is that they are limited in dynamic range by the magnitude of the ICs' supply voltages. In other words, if the magnitude of the voltage being switched or "passed" by the device exceeds the magnitude of the supply voltage (commonly referred to as the "supply rails" or V_{dd}), then significant substrate/well biases (e.g., for the P-type FETs) are developed and substrate/well injection currents are introduced into the IC, which substantially decrease the switch's speed, linearity and overall performance.

The existing analog switch designs typically use very complex well switching schemes to increase the dynamic range of the devices. Other existing analog switches are designed to handle analog signals that exceed the supply rail but work for only one "side" of the switch. However, these devices are not useful for certain applications where the analog voltages to be switched are being input from numerous different sources, such as, for example, in a signal multiplexing application. Typically, the above-described designs increase the complexity and costs of the analog switch ICs, do not significantly increase their dynamic range, and sometimes just cannot be used for certain applications.

### SUMMARY OF THE INVENTION

Accordingly, a need exists in the semiconductor integrated circuit manufacturing industry for a relatively simple high voltage analog switch with an increased dynamic range. In accordance with the present invention, an apparatus is provided that blocks the flow of injection currents in the analog switch caused by substrate biases. These biases are caused, in turn, by input signal voltages that reach or exceed the supply rails. A pair of transistors having the same conductivity type as the switching transistors are connected back-to-back in series and shunted across the analog switch's pass transistor. These shunt transistors function to block the flow of injection currents associated with the switching transistors.

An important technical advantage of the present invention is that by blocking the flow of injection currents caused by high input signal voltages, the dynamic range, speed and performance of the analog switch is significantly improved. Another important technical advantage of the present invention is that the process of adding shunt transistors to the integrated circuit does not increase the device's overall technical complexity. Yet another important technical advantage of the present invention is that the analog switch can be controlled by a single logic input. Still another important technical advantage of the present invention is that each analog switch circuit can be fabricated for use as a "drop-in" standard cell for many applications.

### BRIEF DESCRIPTION OF THE DRAWINGS

For a more complete understanding of the present invention, and the advantages thereof, reference is now made to the following descriptions taken in conjunction with the accompanying drawings, in which:
FIGURE 1 is an electrical schematic circuit diagram of a high voltage analog switch structured according to a preferred embodiment of the present invention.
FIGURE 2 is an electrical schematic circuit diagram illustrating a use of two of the analog switches "EESWITCH" depicted in FIGURE 1 in an exemplary switching application.

### DETAILED DESCRIPTION OF THE INVENTION

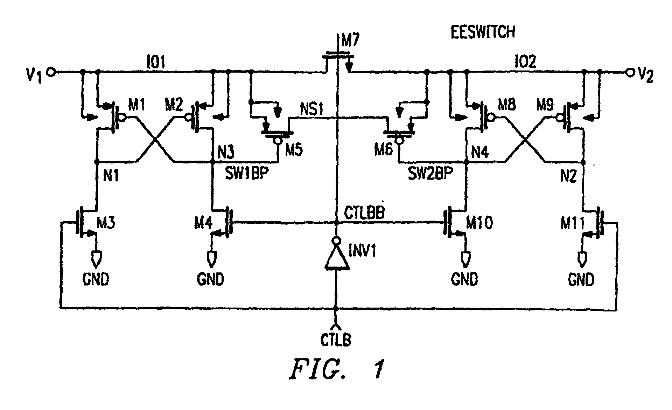

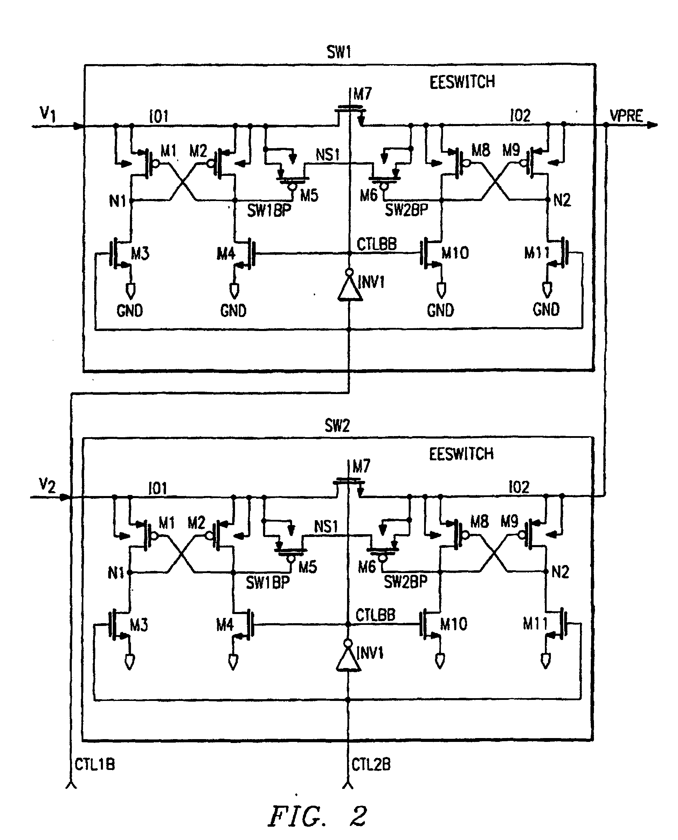

The preferred embodiment of the present invention and its advantages are best understood by referring to FIGURES 1 and 2 of the drawings, like numerals being used for like and corresponding parts of the various drawings.

FIGURE 1 is an electrical schematic circuit diagram of a high voltage analog switch structured according to a preferred embodiment of the present invention. The high voltage analog switch ("EESWITCH"), includes a pair of transistors (preferably MOSFETs) M1 and M2 cross-connected in parallel to form a "pole" of the switch. Preferably, the analog switch shown in FIGURE 1 is fabricated on a single IC chip. However, the invention is not intended to be limited only to a single IC. The sources and "back gates" of transistors M1 and M2 are connected together. The drain of transistor M1 is connected to the "front gate" of transistor M2 and the drain of transistor M3. The source of transistor M3 is connected to circuit "ground." The gate of transistor M3 is connected to an input of inverter INV1 and switch control line CTLB. One analog voltage (V1) to be switched or "passed" by the switch is coupled to the source and "back gate" of transistor M1. The signal at switch control line CTLB is at either a logic "high" or "low" value.

The sources and "back gates" of transistors M1, M2 and M5 are all connected together. The drain of transistor M2 is connected to the "front gate" of transistor M1, the drain of transistor M4, and the "front gate" of transistor M5. The gate of transistor M4 is connected to the output of inverter INV1. The drain of transistor M4 is connected to circuit "ground." In the embodiment illustrated in FIGURE 1, transistors M1, M2 and M5 are shown as P-type devices, and transistors M3 and M4 are N-type devices. However, the invention is not intended to be so limited, and the conductivity types of the devices could be reversed in another embodiment, such as for n-type substrates. For example, transistors M1, M2 and M5 could be N-type devices, while transistors M3 and M4 could be P-type devices.

The source and "back gate" of transistor M5 are also connected to the drain of "pass" transistor M7. Although "pass" transistor M7 is shown in FIGURE 1 as a NMOS device, its conductivity type also could be reversed to "pass" current in the opposite direction (from right to left in FIGURE 1) using, for example, an n-type substrate. The gate of "pass" transistor M7 is connected to the output of inverter INV1. The drains of transistors M5 and M6 are connected together. The drain of "pass" transistor M7 is connected to the drains and "back gates" of transistors M6, M8 and M9. A second analog voltage (V2) to be switched or "passed" by the switch is coupled to the drain and "back gate" of transistor M9. The "front gate" of transistor M6 is connected to the drains of transistors M8 and M10 and the "front gate" of transistor M9. The gate of transistor M10 is connected to the output of inverter INV1, and the source of transistor M10 is connected to circuit "ground." Transistors M8 and M9 are cross-connected to form the second "pole" of the analog switch. The drain of transistor M9 is connected to the "front gate" of transistor M8 and the drain of transistor M11. The gate of transistor M11 is connected to the input control line CTLB and the input of inverter INV1. The source of transistor M11 is connected to circuit "ground." Similar to the conductivity types of transistors M1-M5 and M7 described above, the conductivity types of the P-type devices M6, M8 and M9, and the N-type devices M10 and M-11 illustrated in FIGURE 1, could be reversed, for example, for n-type substrates in another embodiment of the invention.

In operation, the switching function of the high voltage analog switch illustrated in FIGURE 1 is controlled by the logic level ("high" or "low") of the control signal CTLB. Control signal CTLB can be, for example, one bit of a byte or digital word. If control signal CTLB is "high," then transistors M3 and M11 are turned ON. The inverted control signal CTLBB is then "low," which turns transistors M4 and M10 and "pass" transistor M7 OFF. The voltages at nodes N1 and N2 go "low." Since transistors M4 and M10 are OFF, then transistors M5 and M6 are OFF.

However, when control signal CTLB is "low," then transistors M3 and M11 are turned OFF. The inverted control signal CTLBB is now "high," which turns transistors M4 and M10 and "pass" transistor M7 ON. The voltages at nodes N3 and N4 are "low," which turns transistors M1 and M9, and M5 and M6 ON. Consequently, current can flow (from left to right in FIGURE 1) through "pass" transistor M7, and also via a parallel path through transistors M5 and M6. In this embodiment, when the control signal CTLB is "low," then the signal V1 is "passed" through transistor M7 and coupled as an output voltage to the connection labeled V2. Conversely, when the control signal CTLB is "high," then the present analog switch is OFF and no signal is "passed" through transistor M7. An important aspect of the invention is that a parallel current path is provided through transistors M5 and M6, which are arranged in a back-to-back configuration. In this embodiment, these P-type MOS/diffusion devices function as diodes to block injection currents caused by the substrate bias associated with the P-channel switching transistors M1, M2 and M8, M9. These injection currents are created by the biases set up across what are essentially "parasitic diodes" formed at the PN junctions in the P-channel switching transistors. Consequently, these "diodes" (M5 and M6) are configured to allow current flow only in a direction reverse to the injection current attempting to flow through the above-described "parasitic diodes," which functions to block the injection currents associated with the P-channel switching transistors. This blocking function of transistors M5 and M6 thus prevents the injection currents from shunting across the "pass" transistor M7. Therefore, the present analog switch can advantageously "pass" signal voltages linearly which are very close to zero volts or that exceed the supply rails, by blocking the flow of injection currents caused by substrate biases and thereby significantly improving the dynamic range of the present analog switch over existing devices.

FIGURE 2 is an electrical schematic circuit diagram illustrating a use of two of the analog switches "EESWITCH" depicted in FIGURE 1 in an exemplary switching application. Referring to FIGURE 2, a first voltage to be switched is coupled to the input connection V1 of the present analog switch SW1. A second voltage to be switched is coupled to the input connection V2 of analog switch SW2. The outputs of switches SW1 and SW2 are connected together at connection VPRE. Operating in accordance with the present analog switch illustrated and described with respect to FIGURE 1, switch SW1 is ON whenever control signal CTL1B is "low," and switch SW2 is ON whenever control signal CTL2B is "low." Whenever switch SW1 is ON, then the voltage at connection V1 is "passed" through its respective transistor M7 and presented at connection VPRE. Whenever switch SW2 is ON, then the voltage at connection V2 is "passed" through its respective transistor M7 and presented at VPRE. If the control signals CTL1B and CTL2B are different bits in a byte or a word, for example, then the specific voltage at VPRE is determined by the presence of a "high" one of those bits in the control signal for one of the analog switches. Extending this concept, the switching arrangement illustrated in FIGURE 2 can be used, for example, in a signal multiplexer, in which each incoming voltage to be switched to an output of the multiplexer is applied to an input of a respective analog switch. If, for example, signals from eight different sources are to be multiplexed, then the eight signals can be applied to the respective inputs of eight of the analog switches shown in FIGURE 1. The output connections VPRE (FIG. 2) would be connected together. The switching function of each of the eight analog switches could be controlled by a respective control signal CTLB. In accordance with the teachings of the invention, each of the eight analog switches would prevent problems caused by substrate/well injection currents, and the dynamic range of each switch (and the multiplexer's overall performance) would be improved as a result. Furthermore, in accordance with the invention, each switch could be controlled advantageously by a single logical input, which decreases the complexity of such devices. Moreover, additional switches can be fabricated and added as "drop-in" standard cells for more complex switching or multiplexing applications. Also, even much higher signal voltages can be switched (e.g., up to 60V peak) if high voltage transistors such as, for example, DE NMOS, DE PMOS, or LDMOS devices are used in yet another embodiment of the present invention.

## Claims

1. A semiconductor analog switch selectively connecting a first node (V₁) and a second node (V₂) in response to an input control signal (CTLB), comprising:
a pass transistor (M7) including a first gate, a first source directly connected to said first node (V₁) and a first drain directly connected to said second node (V₂);
a first shunt transistor (M5) of a first conductivity type, said first shunt transistor including a second gate, a second source connected to said first node (V₁) and a second drain;
a second shunt transistor (M6) of said first conductivity type, said second shunt transistor including a third gate, a third source connected to said second node (V₂), and a third drain connected to said second drain of said first shunt transistor; and
a drive circuit (M1, M2, M3, M3, M8, M9, M10, M1, INV1) having an input receiving the input control signal (CTLB), a first output (CTLBB) connected to said first gate of said pass transistor, a second output (SW1BP) connected to said second gate of said first shunt transistor and a third output (SW2BP) connected to said third gate of said second shunt transistor, said drive circuit (M1, M2, M3, M3, M8, M9, M10, M1, INV1) responsive to said input control signal (CTLB) to simultaneously render said pass transistor (M7), said first shunt transistor (M5) and said second shunt transistor (M6) conducting for first predetermined states of said input control signal (CTLB) and simultaneously render said pass transistor (M7), said first shunt transistor (M5) and said second shunt transistor (M6) nonconducting for second predetermined states of said input control signal (CTLB) opposite from said first predetermined states.

2. The semiconductor analog switch of Claim 1, wherein:
said pass transistor (M7) has a second conductivity type opposite to said first conductivity type.

3. The semiconductor analog switch of Claim 2, wherein:
said first conductivity type is P type, wherein said first shunt transistor (M5) and said second shunt transistor (M6) are PMOS transistors; and
said second conductivity type is N type, wherein said pass transistor (M7) is an NMOS transistor.

4. The semiconductor analog switch of Claim 2, wherein:
said first conductivity type is N type, wherein said first shunt transistor (M5) and said second shunt transistor (M6) are NMOS transistors; and
said second conductivity type is P type, wherein said pass transistor (M7) is a PMOS transistor.

5. The semiconductor analog switch of claim 1, wherein:
said pass transistor (M7) has said first conductivity type.

6. The semiconductor analog switch of Claim 5, wherein:
said first conductivity type is P type, wherein said pass transistor (M7), said first shunt transistor (M5) and said second shunt transistor (M6) are PMOS transistors.

7. The semiconductor analog switch of Claim 5, wherein:
said first conductivity type is N type, wherein said pass transistor (M7), said first shunt transistor (M5) and said second shunt transistor (M6) are NMOS transistors.

8. The semiconductor analog switch of claim 1, wherein:
said drive circuit includes
an inverter (INV1) having an input receiving said input control signal and an output connected to said gate of said pass transistor (M7),
a first drive transistor (M1) of said first conductivity type having a fourth gate, a fourth source connected to said first node (V₁), and a fourth drain,
a second drive transistor (M2) of said first conductivity type having a fifth gate connected to said fourth drain of said first drive transistor (M1), a fifth source connected to said first node (V₁), and a fifth drain connected to said second gate of said first shunt transistor (M5) and said fourth gate of said first drive transistor (M1),
a third drive transistor (M3) of a second conductivity type opposite to said first conductivity type having a sixth gate receiving said input control signal (CTLB), a sixth drain connected to said fourth drain of said first drive transistor (M1) and said fifth gate of said second drive transistor (M2) and a sixth source connected to ground (GND),
a fourth drive transistor (M4) of said second conductivity type having a seventh gate connected to said output of said inverter (INV1), a seventh drain connected to said fourth gate of said first drive transistor (M1), said drain of said second drive transistor (M2) and said second gate of said first shunt transistor (M5) and a seventh source connected to ground (GND),
a fifth drive transistor (M9) of said first conductivity type having an eighth gate, an eighth source connected to said second node (V₂), and an eighth drain,
a sixth drive transistor (M8) of said first conductivity type having a ninth gate connected to said eighth drain of said fifth drive transistor (M9), a ninth source connected to said second node (V₂), and a ninth drain connected to said third gate of said second shunt transistor (M6) and said eighth gate of said fifth drive transistor (M9),
a seventh drive transistor (M11) of said second conductivity type having a tenth gate receiving said input signal (CTLB), a tenth drain connected to said ninth gate of said sixth drive transistor (M8) and said eighth drain of said fifth drive transistor (M9) and a tenth source connected to ground (GND), and
an eighth drive transistor (M10) of said second conductivity type having an eleventh gate connected to said output of said inverter (INV1), an eleventh drain connected to said eighth gate of said fifth drive transistor (M9), said ninth drain of said sixth drive transistor (M8) and to said third gate of said second shunt transistor and an eleventh source connected to ground (GND).

9. The semiconductor analog switch of Claim 1, wherein said first control signal (CTLB) comprises a logic level signal.

10. The semiconductor analog switch of Claim 1, wherein said first control signal (CTLB) comprises a binary digit.

## Patentansprüche

1. Halbleiter-Analogschalter, der selektiv einen ersten Schaltungspunkt (V₁) und einen zweiten Schaltungspunkt (V₂) ansprechend auf ein Eingangssteuersignal (CTLB) anlegt, mit:
einem Schalttransistor (M7), der einen ersten Gate-Anschluß, einen ersten Source-Anschluß, der direkt mit dem ersten Schaltungspunkt (V₁) verbunden ist, und einen ersten Drain-Anschluß, der direkt mit dem zweiten Schaltungspunkt (V₂) verbunden ist, aufweist,
einem ersten Nebenschlußtransistor (M5) von einem ersten Leitfähigkeitstyp, wobei der erste Nebenschlußtransistor einen zweiten Gate-Anschluß, einen zweiten Source-Anschluß, der mit dem ersten Schaltungspunkt (V₁) verbunden ist, und einen zweiten Drain-Anschluß aufweist,
einem zweiten Nebenschlußtransistor (M6) des ersten Leitfähigkeitstyps, wobei der zweite Nebenschlußtransistor einen dritten Gate-Anschluß, einen dritten Source-Anschluß, der mit dem zweiten Schaltungspunkt (V₂) verbunden ist, und einen dritten Drain-Anschluß, der mit dem zweiten Drain-Anschluß des ersten Nebenschlußtransistors verbunden ist, aufweist und
einer Ansteuerschaltung (M1, M2, M3, M3, M8, M9, M10, M1, INV1), die einen Eingang, der das Eingangssteuersignal (CTLB) empfängt, einen ersten Ausgang (CTLBB), der an den ersten Gate-Anschluß des Schalttransistors angeschlossen ist, einen zweiten Ausgang (SW1BP), der an den zweiten Gate-Anschluß des ersten Nebenschlußtransistors angeschlossen ist, und einen dritten Ausgang (SW2BP), der an den dritten Gate-Anschluß des zweiten Nebenschlußtransistors angeschlossen ist, aufweist, wobei die Ansteuerschaltung (M1, M2, M3, M3, M8, M9, M10, M1, INV1) so auf das Eingangssteuersignal (CTLB) anspricht, daß sie den Schalttransistor (M7), den ersten Nebenschlußtransistor (M5) und den zweiten Nebenschlußtransistor (M6) für erste vorbestimmte Zustände des Eingangssteuersignals (CTLB) gleichzeitig leitend macht und den Schalttransistor (M7), den ersten Nebenschlußtransistor (M5) und den zweiten Nebenschlußtransistor (M6) für zweite vorbestimmte Zustände des Eingangssteuersignals (CTLB), die den ersten vorbestimmten Zuständen entgegengesetzt sind, gleichzeitig nichtleitend macht.

2. Halbleiter-Analogschalter nach Anspruch 1, wobei
der Schalttransistor (M7) einen zweiten Leitfähigkeitstyp aufweist, der dem ersten Leitfähigkeitstyp entgegengesetzt ist.

3. Halbleiter-Analogschalter nach Anspruch 2, wobei
der erste Leitfähigkeitstyp der P-Typ ist, wobei der erste Nebenschlußtransistor (M5) und der zweite Nebenschlußtransistor (M6) PMOS-Transistoren sind, und
der zweite Leitfähigkeitstyp der N-Typ ist, wobei der Schalttransistor (M7) ein NMOS-Transistor ist.

4. Halbleiter-Analogschalter nach Anspruch 2, wobei
der erste Leitfähigkeitstyp der N-Typ ist, wobei der erste Nebenschiußtransistor (M5) und der zweite Nebenschlußtransistor (M6) NMOS-Transistoren sind, und
der zweite Leitfähigkeitstyp der P-Typ ist, wobei der Schalttransistor (M7) ein PMOS-Transistor ist.

5. Halbleiter-Analogschalter nach Anspruch 1, wobei
der Schalttransistor (M7) den ersten Leitfähigkeitstyp aufweist.

6. Halbleiter-Analogschalter nach Anspruch 5, wobei
der erste Leitfähigkeitstyp der P-Typ ist, wobei der Schalttransistor (M7), der erste Nebenschlußtransistor (M5) und der zweite Nebenschlußtransistor (M6) PMOS-Transistoren sind.

7. Halbleiter-Analogschalter nach Anspruch 5, wobei
der erste Leitfähigkeitstyp der N-Typ ist, wobei der Schalttransistor (M7), der erste Nebenschlußtransistor (M5) und der zweite Nebenschlußtransistor (M6) NMOS-Transistoren sind.

8. Halbleiter-Analogschalter nach Anspruch 1, wobei die Ansteuerschaltung aufweist:
einen Inverter (INV1) mit einem Eingang, der das Eingangssteuersignal empfängt, und einem Ausgang, der an den Gate-Anschluß des Schalttransistors (M7) angeschlossen ist,
einen ersten Steuertransistor (M1) des ersten Leitfähigkeitstyps mit einem vierten Gate-Anschluß, einem vierten Source-Anschluß, der mit dem ersten Schaltungspunkt (V₁) verbunden ist, und einem vierten Drain-Anschluß,
einen zweiten Steuertransistor (M2) des ersten Leitfähigkeitstyps mit einem fünften Gate-Anschluß, der mit dem vierten Drain-Anschluß des ersten Steuertransistors (M1) verbunden ist, einem fünften Source-Anschluß, der mit dem ersten Schaltungspunkt (V₁) verbunden ist, und einem fünften Drain-Anschluß, der mit dem zweiten Gate-Anschluß des ersten Nebenschlußtransistors (M5) und dem vierten Gate-Anschluß des ersten Steuertransistors (M1) verbunden ist,
einen dritten Steuertransistor (M3) eines zweiten Leitfähigkeitstyps, der dem ersten Leitfähigkeitstyp entgegengesetzt ist, mit einem sechsten Gate-Anschluß, der das Eingangssteuersignal (CTLB) empfängt, einem sechsten Drain-Anschluß, der mit dem vierten Drain-Anschluß des ersten Steuertransistors (M1) und dem fünften Gate-Anschluß des zweiten Steuertransistors (M2) verbunden ist, und einem sechsten Source-Anschluß, der an Masse (GND) gelegt ist,
einen vierten Steuertransistor (M4) des zweiten Leitfähigkeitstyps mit einem siebten Gate-Anschluß, der mit dem Ausgang des Inverters (INV1) verbunden ist, einem siebten Drain-Anschluß, der mit dem vierten Gate-Anschluß des ersten Steuertransistors (M1), dem Drain-Anschluß des zweiten Steuertransistors (M2) und dem zweiten Gate-Anschluß des ersten Nebenschlußtransistors (M5) verbunden ist, und einem siebten Source-Anschluß, der an Masse (GND) gelegt ist,
einen fünften Steuertransistor (M9) des ersten Leitfähigkeitstyps mit einem achten Gate-Anschluß, einem achten Source-Anschluß, der mit dem zweiten Schaltungspunkt (V₂) verbunden ist, und einem achten Drain-Anschluß,
einen sechsten Steuertransistor (M8) des ersten Leitfähigkeitstyps mit einem neunten Gate-Anschluß, der mit dem achten Drain-Anschluß des fünften Steuertransistors (M9) verbunden ist, einem neunten Source-Anschluß, der mit dem zweiten Schaltungspunkt (V₂) verbunden ist, und einem neunten Drain-Anschluß, der mit dem dritten Gate-Anschluß des zweiten Nebenschlußtransistors (M6) und dem achten Gate-Anschluß des fünften Steuertransistors (M9) verbunden ist,
einen siebten Steuertransistor (M11) des zweiten Leitfähigkeitstyps mit einem zehnten Gate-Anschluß, der das Eingangssignal (CTLB) empfängt, einem zehnten Drain-Anschluß, der mit dem neunten Gate-Anschluß des sechsten Steuertransistors (M8) und dem achten Drain-Anschluß des fünften Steuertransistors (M9) verbunden ist, und einem zehnten Source-Anschluß, der an Masse (GND) gelegt ist, und
einen achten Steuertransistor (M10) des zweiten Leitfähigkeitstyps mit einem elften Gate-Anschluß, der mit dem Ausgang des Inverters (INV1) verbunden ist, einem elften Drain-Anschluß, der mit dem achten Gate-Anschluß des fünften Steuertransistors (M9), dem neunten Drain-Anschluß des sechsten Steuertransistors (M8) und dem dritten Gate-Anschluß des zweiten Nebenschlußtransistors verbunden ist, und einem elften Source-Anschluß, der an Masse (GND) gelegt ist.

9. Halbleiter-Analogschalter nach Anspruch 1, wobei das erste Steuersignal (CTLB) ein Logikpegel-Signal umfaßt.

10. Halbleiter-Analogschalter nach Anspruch 1, wobei das erste Steuersignal (CTLB) ein binäres Element umfaßt.

## Revendications

1. Commutateur analogique à semi-conducteur connectant sélectivement un premier noeud (V₁) et un deuxième noeud (V₂) en réponse à un signal de commande d'entrée (CTLB), comprenant :
un transistor de "passage" (M7) incluant une première grille, une première source directement connectée audit premier noeud (V₁) et un premier drain directement connecté audit deuxième noeud (V₂) ;
un premier transistor en dérivation (M5) d'un premier type de conductivité, ledit premier transistor en dérivation incluant une deuxième grille, une deuxième source connectée audit premier noeud (V₁) et un deuxième drain ;
un deuxième transistor en dérivation (M6) dudit premier type de conductivité, ledit deuxième transistor en dérivation incluant une troisième grille, une troisième source connectée audit deuxième noeud (V₂), et un troisième drain connecté audit deuxième drain dudit premier transistor en dérivation ; et
un circuit de commande (M1, M2, M3, M3, M8, M9, M10, M1, INV1) ayant une entrée recevant le signal de commande d'entrée (CTLB), une première sortie (CTLBB) connectée à ladite première grille dudit transistor de "passage", une deuxième sortie (SW1BP) connectée à ladite deuxième grille dudit premier transistor en dérivation et une troisième sortie (SW2BP) connectée à ladite troisième grille dudit deuxième transistor en dérivation, ledit circuit de commande (M1, M2, M3, M3, M8, M9, M10, M1, INV1) étant sensible audit signal de commande d'entrée (CTLB) pour rendre conducteur simultanément ledit transistor de "passage" (M7), ledit premier transistor en dérivation (M5) et ledit deuxième transistor en dérivation (M6) pour des premiers états prédéterminés dudit signal de commande d'entrée (CTLB) et pour rendre simultanément non conducteur ledit transistor de passage (M7), ledit premier transistor en dérivation (M5) et ledit deuxième transistor en dérivation (M6) pendant des deuxièmes états prédéterminés dudit signal de commande d'entrée (CTLB) opposés auxdits premiers états prédéterminés.

2. Commutateur analogique à semi-conducteur selon la revendication 1, dans lequel ledit transistor de "passage" (M7) a un deuxième type de conductivité opposé audit premier type de conductivité.

3. Commutateur analogique à semi-conducteur selon la revendication 2, dans lequel ledit premier type de conductivité est le type P, dans lequel ledit premier transistor en dérivation (M5) et ledit deuxième transistor en dérivation (M6) sont des transistors PMOS ; et ledit deuxième type de conductivité est le type N, dans lequel ledit transistor de "passage" (M7) est un transistor NMOS.

4. Commutateur analogique à semi-conducteur selon la revendication 2, dans lequel ledit premier type de conductivité est le type N, dans lequel ledit premier transistor en dérivation (M5) et ledit deuxième transistor en dérivation (M6) sont des transistors NMOS ; et ledit deuxième type de conductivité est le type P, dans lequel ledit transistor de "passage" (M7) est un transistor PMOS.

5. Commutateur analogique à semi-conducteur selon la revendication 1, dans lequel ledit transistor de "passage" (M7) a ledit premier type de conductivité.

6. Commutateur analogique selon la revendication 5 dans lequel ledit premier type de conductivité est le type P, dans lequel ledit transistor de "passage" (M7), ledit premier transistor en dérivation (M5) et ledit deuxième transistor en dérivation (M6) sont des transistors PMOS.

7. Commutateur analogique selon la revendication 5 dans lequel ledit premier type de conductivité est le type N, dans lequel ledit transistor de "passage" (M7), ledit premier transistor en dérivation (M5) et ledit deuxième transistor en dérivation (M6) sont des transistors NMOS.

8. Commutateur analogique à semi-conducteur selon la revendication 1, dans lequel : ledit circuit de commande inclut
un inverseur (INV1) ayant une entrée recevant ledit signal de commande d'entrée et une sortie connectée à ladite grille dudit transistor de "passage" (M7),
un premier transistor de commande (M1) dudit premier type de conductivité ayant une quatrième grille, une quatrième source connectée audit premier noeud (V₁), et un quatrième drain,
un deuxième transistor de commande (M2) dudit premier type de conductivité ayant une cinquième grille connectée audit quatrième drain dudit premier transistor de commande (M1), une cinquième source connectée audit premier noeud (V₁), et un cinquième drain connecté à ladite deuxième grille dudit premier transistor en dérivation (M5) et à ladite quatrième grille dudit premier transistor de commande (M1),
un troisième transistor de commande (M3) d'un deuxième type de conductivité opposé audit premier type de conductivité ayant une sixième grille recevant ledit signal de commande d'entrée (CTLB), un sixième drain connecté audit quatrième drain dudit premier transistor de commande (M1) et à ladite cinquième grille dudit deuxième transistor de commande (M2) et une sixième source connectée à la masse (GND),
un quatrième transistor de commande (M4) dudit deuxième type de conductivité ayant une septième grille connectée à ladite sortie dudit inverseur (INV1), un septième drain connecté à ladite quatrième grille dudit premier transistor de commande (M1), audit drain dudit deuxième transistor de commande (M2) et à ladite deuxième grille dudit premier transistor en dérivation (M5) et une septième source connectée à la masse (GND),
un cinquième transistor de commande (M9) dudit premier type de conductivité ayant une huitième grille, une huitième source connectée audit deuxième noeud (V₂), et un huitième drain,
un sixième transistor de commande (M8) dudit premier type de conductivité ayant une neuvième grille connectée audit huitième drain dudit cinquième transistor de commande (M9), une neuvième source connectée audit deuxième noeud (V₂) et un neuvième drain connecté à ladite troisième grille dudit deuxième transistor en dérivation (M6) et à ladite huitième grille dudit cinquième transistor de commande (M9),
un septième transistor de commande (M11) dudit deuxième type de conductivité ayant une dixième grille recevant ledit signal d'entrée (CTLB), un dixième drain connecté à ladite neuvième grille dudit sixième transistor de commande (M8) et audit huitième drain dudit cinquième transistor de commande (M9) et une dixième source connectée à la masse (GND), et
un huitième transistor de commande (M10) dudit deuxième type de conductivité ayant une onzième grille connectée à ladite sortie dudit inverseur (INV1), un onzième drain connecté à ladite huitième grille dudit cinquième transistor de commande (M9), audit neuvième drain dudit sixième transistor de commande (M8) et à ladite troisième grille dudit deuxième transistor en dérivation et une onzième source connectée à la masse (GND).

9. Commutateur analogique à semi-conducteur selon la revendication 1, dans lequel ledit premier signal de commande (CTLB) comprend un signal de niveau logique.

10. Commutateur analogique à semi-conducteur selon la revendication 1, dans lequel ledit premier signal de commande (CTLB) comprend un chiffre binaire.
